(19) **Europäisches Patentamt / European Patent Office / Office européen des brevets**

(11) **EP 4 676 183 A1**

(12) **EUROPEAN PATENT APPLICATION**

(43) Date of publication:
07.01.2026 Bulletin 2026/02

(21) Application number: 25184253.0

(22) Date of filing: 20.06.2025

(51) International Patent Classification (IPC):
*H10B 51/30* (2023.01)  *H10B 43/20* (2023.01)
*H10B 43/30* (2023.01)  *H10B 51/20* (2023.01)
*H10D 64/68* (2025.01)

(52) Cooperative Patent Classification (CPC):
**H10B 51/30; H10B 43/20; H10B 43/30;
H10B 51/20;** H10D 64/68

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: 01.07.2024 KR 20240086350

(71) Applicant: **Samsung Electronics Co., Ltd.**
**Suwon-si, Gyeonggi-do 16677 (KR)**

(72) Inventors:
• **KIM, Sungmin**
**Suwon-si 16677 (KR)**
• **KIM, Deokhwan**
**Suwon-si 16677 (KR)**
• **KIM, Jaemyeong**
**Suwon-si 16677 (KR)**
• **KIM, Jeonggeol**
**Suwon-si 16677 (KR)**
• **LEE, Yongkyung**
**Suwon-si 16677 (KR)**

(74) Representative: **Elkington and Fife LLP**
**Prospect House**
**8 Pembroke Road**
**Sevenoaks, Kent TN13 1XR (GB)**

(54) **VERTICALLY STACKED TRANSISTOR STRUCTURE AND NEURAL NETWORK DEVICE INCLUDING THE SAME**

(57) A vertically stacked transistor structure may include a first transistor and a second transistor on the first transistor in a first direction. The first transistor may include a first channel, a first source region, a first drain region, a first gate insulating layer, and a first gate electrode. The second transistor may include a second channel, a second source region, a second drain region, a second gate insulating layer, and a second gate electrode. One of the first gate insulating layer and the second gate insulating layer may include a paraelectric material. The other one of the first gate insulating layer and the second gate insulating layer may include a data recording material.

FIG. 4

EP 4 676 183 A1

**Description**

FIELD OF THE INVENTION

The disclosure relates to a vertically stacked transistor structure and/or a neural network device including the same.

BACKGROUND OF THE INVENTION

Interest has increased in neuromorphic processors that perform neural network operations. A neuromorphic processor may be used as a neural network device for driving various neural networks, such as a convolutional neural network (CNN), a recurrent neural network (RNN), and a feedforward neural network (FNN), and may be utilized in fields including data classification or image recognition.

A neuromorphic processor may include a plurality of synaptic devices for storing weight. Synaptic devices may be implemented with various elements. Recently, synaptic devices capable of implementing in-memory computing (IMC) have been proposed in order to reduce heat generation and/or lower power consumption of neuromorphic processors.

SUMMARY OF THE INVENTION

Provided is a vertically stacked transistor structure capable of implementing in-memory computing and/or having a small area.

In addition, provided is a neural network device capable of manufacturing with improved integration using a vertically stacked transistor structure.

Additional aspects will be set forth in part in the description which follows and, in part, will be apparent from the description, or may be learned by practice of the presented embodiments of the disclosure.

According to an aspect of an embodiment, a vertically stacked transistor structure may include a first transistor including a first channel, a first source region, a first drain region, a first gate insulating layer, and a first gate electrode; and a second transistor on the first transistor in a first direction and including a second channel, a second source region, a second drain region, a second gate insulating layer, and a second gate electrode. One of the first gate insulating layer and the second gate insulating layer may include a paraelectric material. The other of the first gate insulating layer and the second gate insulating may include a data recording material.

In some embodiments, the first source region, the first channel, and the first drain region of the first transistor may be sequentially provided in a second direction. The second direction may be perpendicular to the first direction. The second drain region, the second channel, and the second source region of the second transistor may be sequentially provided in the second direction.

In some embodiments, the first channel of the first transistor may face the second channel of the second transistor. The first channel of the first transistor and the second channel of the second transistor may be spaced apart from each other in the first direction. The first source region of the first transistor may face the second drain region of the second transistor. The first source region of the first transistor and the second drain region of the second transistor may be spaced apart from each other in the first direction. The first drain region of the first transistor may face the second source region of the second transistor. The first drain region of the first transistor and the second source region of the second transistor may be spaced apart from each other in the first direction.

In some embodiments, a distance between the first channel of the first transistor and the second channel of the second transistor in the first direction may be 3 nm to 30 nm.

In some embodiments, the vertically stacked transistor structure may further include an insulating layer. The insulating layer may be between the first source region of the first transistor and the second drain region of the second transistor. The first source region of the first transistor and the second drain region of the second transistor may face each other. The insulating layer may be between the first drain region of the first transistor and the second source region of the second transistor. The first drain region of the first transistor and the second source region of the second transistor may face each other.

In some embodiments, the first gate insulating layer may surround the first channel, the first gate electrode may surround the first gate insulating layer, the second gate insulating layer may surround the second channel, and the second gate electrode may surround the second gate insulating layer.

In some embodiments, the first gate electrode of the first transistor may face the second gate electrode of the second transistor, and the first gate electrode of the first transistor and the second gate electrode of the second transistor may be spaced apart from each other in the first direction.

In some embodiments, the vertically stacked transistor structure may further include an insulating layer between the first gate electrode of the first transistor and the second gate electrode of the second transistor.

In some embodiments, the first gate insulating layer may surround three surfaces of the first channel, and the second gate insulating layer may surround three surfaces of the second channel.

In some embodiments, the first gate insulating layer may surround three surfaces of the first channel, and the second gate insulating layer may surround four surfaces of the second channel.

In some embodiments, the first gate insulating layer may surround four surfaces of the first channel, and the second gate insulating layer may surround three surfaces of the second channel.

In some embodiments, the first gate insulating layer may surround four surfaces of the first channel, and the second gate insulating layer may surround four surfaces of the second channel.

In some embodiments, the vertical stacked transistor structure may further include spacers extending in the first direction. The spacers may contact both sides of the first gate insulating layer and both sides of the first gate electrode of the first transistor in a second direction. The spacers may contact both sides of the second gate insulating layer and both sides of the second gate electrode of the second transistor in the second direction. The second direction may be perpendicular to the first direction.

In some embodiments, the vertically stacked transistor structure may further include a substrate, and the first channel, the first source region, and the first drain region of the first transistor may protrude from an upper surface of the substrate in the first direction.

In some embodiments, the vertically stacked transistor structure may further include a conductor extending in the first direction and electrically connecting the first drain region of the first transistor with the second source region of the second transistor.

In some embodiments, the vertically stacked transistor structure may further include a conductor electrically connecting the first drain region of the first transistor with the second gate electrode of the second transistor.

In some embodiments, the data recording material may include a ferroelectric material or a charge trap material having an oxide-nitride-oxide (ONO) multilayer structure.

According to an embodiment, a neural network device may include an array of a plurality of synaptic devices arranged in two dimensions along a plurality of rows and a plurality of columns. The plurality of synaptic devices may include a vertically stacked transistor structure. The vertically stacked transistor structure may include a first transistor and a second transistor. The first transistor may include a first channel, a first source region, a first drain region, a first gate insulating layer, and a first gate electrode. The second transistor may be on the first transistor in a first direction. The second transistor may include a second channel, a second source region, a second drain region, a second gate insulating layer, and a second gate electrode. One of the first gate insulating layer and the second gate insulating layer may include a paraelectric material. An other of the first gate insulating layer and the second gate insulating layer may include a data recording material.

In some embodiments, the first drain region of the first transistor may be electrically connected to the second source region of the second transistor.

In some embodiments, the first drain region of the first transistor may be electrically connected to the second gate electrode of the second transistor.

## BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a diagram for explaining an architecture of a neural network according to an embodiment;
FIG. 2 is a diagram for explaining an arithmetic operation performed in a neural network according to an embodiment;
FIG. 3 is a circuit diagram schematically illustrating a structure of a neural network device according to an embodiment;
FIGS. 4 and 5 are cross-sectional views illustrating a vertically stacked transistor structure of a synaptic device according to an embodiment;
FIGS. 6A to 6K are perspective views illustrating a process of manufacturing a vertically stacked transistor structure of a synaptic device according to an embodiment;
FIG. 7 is a perspective view illustrating a plurality of vertically stacked transistor structures of a plurality of synaptic devices arranged along one row;
FIG. 8 is a cross-sectional view illustrating a vertically stacked transistor structure of a synaptic device according to another embodiment;
FIG. 9 is a cross-sectional view illustrating a vertically stacked transistor structure of a synaptic device according to another embodiment;
FIG. 10 is a cross-sectional view illustrating a vertically stacked transistor structure of a synaptic device according to another embodiment;
FIG. 11 is a cross-sectional view illustrating a vertically stacked transistor structure of a synaptic device according to another embodiment;
FIG. 12 is a cross-sectional view illustrating a vertically stacked transistor structure of a synaptic device according to another embodiment;
FIG. 13 is a circuit diagram schematically illustrating a structure of a neural network device according to another embodiment;
FIG. 14 is a cross-sectional view illustrating a vertically stacked transistor structure of a synaptic device included in the neural network device illustrated in FIG. 13; and
FIG. 15 is a schematic block diagram showing an example configuration of an electronic apparatus including a neural network device.

## DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, a vertically stacked transistor structure and a neural network device including the same are described in detail with reference to the accompanying drawings. In the following drawings, the same reference numerals refer to the same components, and the size of each component in the drawings may be exaggerated for clarity and convenience of description. In addition, the embodiments described below are merely examples and various modifications are possible from these embodiments.

Hereinafter, the term "upper portion/lower portion" or "above/below" may also include "to be present above/below on a non-contact basis" as well as "to be present above/below on a direct contact basis". The singular expression includes multiple expressions unless the context clearly implies otherwise. In addition, when a part "includes" a component, this means that it may further include other components, not excluding other components unless otherwise opposed.

The use of the term "the" and similar indicative terms may correspond to both singular and plural. If there is no explicit description of an order for steps that make up a method or vice versa, these steps can be done in an appropriate order and are not necessarily limited to the order described.

Further, the terms "unit", "module" or the like mean a unit that processes at least one function or operation, which may be implemented in hardware or software or implemented in a combination of hardware and software.

The connection or connection members of lines between the components shown in the drawings exemplarily represent functional connection and/or physical or circuit connections, and may be replaceable or represented as various additional functional connections, physical connections, or circuit connections in an actual device.

When the terms "about" or "substantially" are used in this specification in connection with a numerical value, it is intended that the associated numerical value includes a manufacturing or operational tolerance (e.g., $\pm$10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., $\pm$10%) around the stated numerical values or shapes. When ranges are specified, the range includes all values therebetween such as increments of 0.1%.

The use of all examples or example terms is simply to describe technical ideas in detail, and the scope is not limited by these examples or example terms unless the scope is limited by the claims.

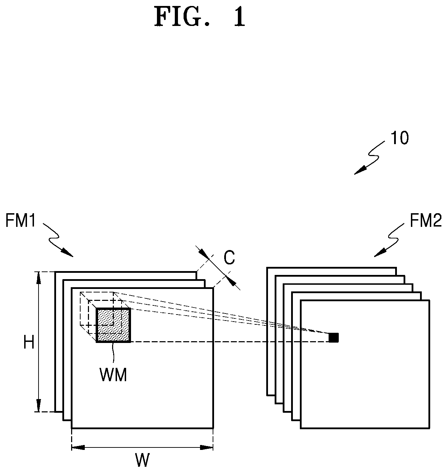

FIG. 1 is a diagram for explaining an architecture of a neural network 10 according to an embodiment. Referring to FIG. 1, the neural network 10 according to an embodiment may be represented by a mathematical model using nodes and edges. The neural network 10 may be an architecture of a deep neural network (DNN) or n-layers neural networks. The DNN or n-layers neural networks may include convolutional neural network (CNN), recurrent neural network (RNN), feedback neural network (FNN), long short-term memory (LSTM), stacked neural network (SNN), state-space dynamic neural network (SSDNN), deep belief network (DBN), restricted Boltzmann machine (RBM), and the like. For example, the neural network 10 may be implemented as a CNN, but is not limited thereto. The neural network 10 of FIG. 1 may correspond to some layers of the CNN. Accordingly, the neural network 10 may correspond to a convolution layer, a pooling layer, a fully connected layer, or the like of the CNN. However, hereinafter, for convenience of explanation, it will be assumed that the neural network 10 corresponds to the convolution layer of the CNN.

In the convolution layer, a first feature map FM1 may correspond to an input feature map, and a second feature map FM2 may correspond to an output feature map. The feature map may mean a data set in which various characteristics of input data are expressed. The feature maps FM1 and FM2 may be high-dimensional matrices of two-dimensional or more and have activation parameters, respectively. When the feature maps FM1 and FM2 correspond to, for example, three-dimensional feature maps, the feature maps FM1 and FM2 have a width W (or referred to as a column), a height H (or a row), and a depth C. In this case, the depth C may correspond to the number of channels.

In the convolution layer, a convolution operation on the first feature map FM1 and a weight map WM may be performed, and as a result, the second feature map FM2 may be generated. The weight map WM may filter the first feature map FM1 and is referred to as a weight filter or a weight kernel. In an example, the depth of the weight map WM, that is, the number of channels, is the same as the depth of the first feature map FM1, that is, the number of channels. The weight map WM is shifted to transverse the first feature map FM1 as a sliding window. During each shift, each of the weights included in the weight map WM may be multiplied by and added to all feature values in a region overlapping the first feature map FM1. As the first feature map FM1 and the weight map WM are convoluted, one channel of the second feature map FM2 may be generated.

Although one weight map WM is illustrated in FIG. 1, a plurality of weight maps may be substantially convoluted with the first feature map FM1 to generate a plurality of channels of the second feature map FM2. Meanwhile, the second feature map FM2 of the convolution layer may be an input feature map of the next layer. For example, the second feature map FM2 may be an input feature map of a pooling layer. However, the embodiment is not limited thereto.

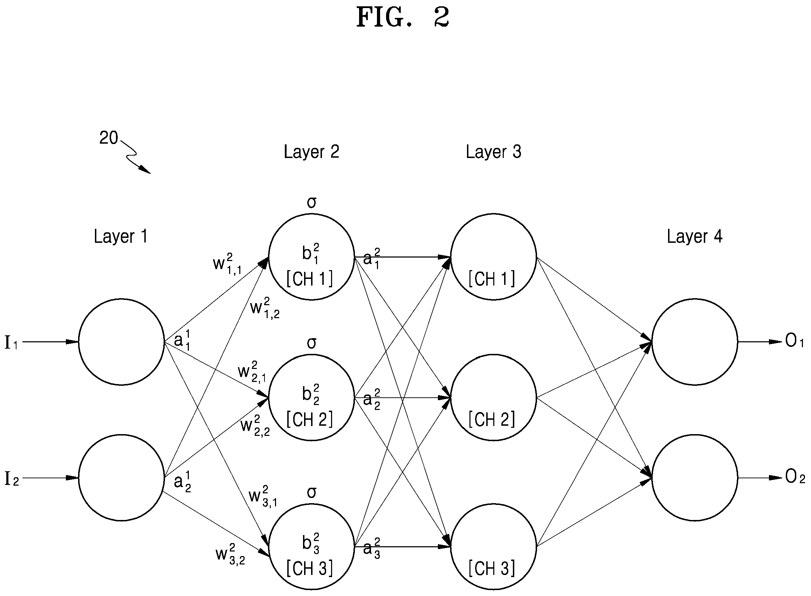

FIG. 2 is a diagram for explaining an arithmetic operation performed in a neural network according to an embodiment. Referring to FIG. 2, the neural network 20 may have a structure including an input layer, hidden layers, and an output layer. The neural network 20 may perform an operation based on received input data (e.g., $I_1$ and $I_2$), and may generate output data (e.g., $O_1$ and $O_2$) based on the arithmetic operation performance result.

As described above, the neural network 20 may include a DNN or n-layers neural network including two or more hidden layers. For example, as shown in FIG. 2, the neural network 20 may be a DNN including an input layer (Layer 1), two hidden layers (Layer 2 and Layer 3), and an output layer (Layer 4). When the neural network 20 is implemented as a DNN architecture, it includes more layers capable of processing valid information, so the neural network 20 may process more complex datasets than a neural network with a single layer. Meanwhile, the neural network 20 is illustrated as including four layers, but this is only an example, and the neural network 20 may include less or more layers, or may include less or more channels. In other words, the neural network 20 may include layers of various structures different from those illustrated in FIG. 2.

Each of the layers included in the neural network 20 may include a plurality of channels. The channel may correspond to a plurality of artificial nodes, known as a neuron, a processing element (PE), a unit, or similar terms. For example, as shown in FIG. 2, Layer 1 may include two channels (nodes), and each of Layer 2 and Layer 3 may include three channels. However, this is only an example, and each of the layers included in the neural network 20 may include various numbers of channels (nodes).

Channels included in each of the layers of the neural network 20 may be connected to each other to process data. For example, one channel may receive data from other channels to perform an arithmetic operation and may output the arithmetic operation result to other channels.

The input and output of the channel may be referred to as an input activation and an output activation, respectively. In other words, the activation may be a parameter corresponding to an output of one channel and simultaneously inputs of channels included in the next layer. Meanwhile, each of the channels may determine its own activation based on activations and weights received from channels included in the previous layer. The weight is a parameter used to calculate output activation in each channel and may be a value allocated to a connection relationship between channels.

Each of the channels may be processed by a computational unit or processing element that receives an input and outputs an output activation, and the input-output of each of the channels may be mapped. For example, $\sigma$ is an activation function, $w^i_{jk}$ is the weight from the k-th channel included in the (i-1)-th layer to the j-th channel included in the i-th layer, $b^i_j$ is the bias of the j-th channel included in the i-th layer, and when $a^i_j$ is the activation of the j-th channel included in the i-th layer, the activation $a^i_j$ may be calculated by using the following Equation 1.

[Equation 1]

$$a^i_j = \sigma\left(\sum_k (w^i_{jk} \times a^{i-1}_k) + b^i_j\right)$$

As shown in FIG. 2, the activation of the first channel CH1 of the second layer 2 may be represented by $a^2_1$. In addition, $a^2_1$ may have a value that $a^2_1 = \sigma(w^2_{11} \times a^1_1 + w^2_{12} \times a^1_2 + b^2_1)$, according to Equation 1. The activation function $\sigma$ may be a Rectified Linear Unit (ReLU), but is not limited thereto. For example, the activation function $\sigma$ may be a sigmoid, a hyperbolic tangent tanh, a maxout, or the like.

As described above, in the neural network 20, numerous datasets may be exchanged between multiple interconnected channels and undergo an arithmetic operation process passing through the layer. In such an arithmetic operation process, a number of multiply-accumulate (MAC) operations are performed, and a number of memory access operations to load activations and weights, which are operands of MAC operations at an appropriate point in time, should be performed together.

A typical digital computer may use a Von Neumann architecture that separates a computational unit and a memory and includes a common data bus for data transfer between two separated blocks. Therefore, in the process of performing the neural network 20 in which the data movement and arithmetic operation are continuously repeated, a large amount of time may be required for data transmission, and excessive power may be consumed; consequently, heat generation may be increased. To enhance this, an in-memory computing neural network device has been proposed as an architecture that integrates, into one, memory and operation units for performing multiply-accumulate (MAC) operations.

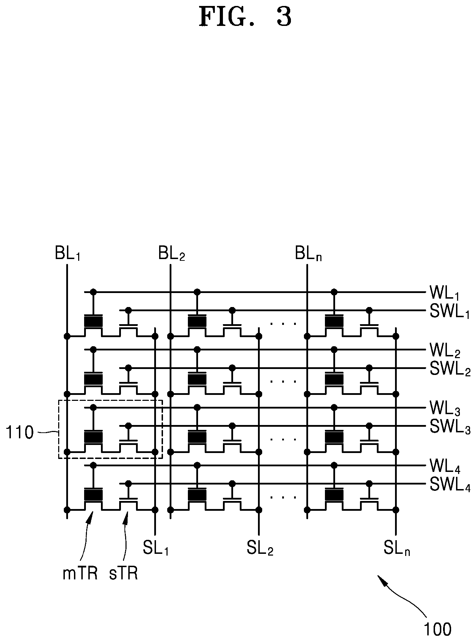

FIG. 3 is a circuit diagram schematically illustrating a structure of a neural network device according to an embodiment. The neural network device 100 according to FIG. 3 is an in-memory computing neural network device in which memory and computation units for performing MAC operations are integrated into one. Referring to FIG. 3, a neural network device 100 may include an array of a plurality of synaptic devices 110 arranged in two dimensions along a plurality of rows and a plurality of columns. Each of the plurality of synaptic devices 110 may include (or consist of) one select transistor sTR and one memory transistor mTR. The select transistor sTR and the memory transistor mTR may be connected in series to each other in each synaptic device 110. For example, the drain region of the select transistor sTR and the source region of the memory transistor mTR may be connected to each other. The select transistor sTR may serve to select whether or not the memory transistor mTR connected thereto is operated. The memory transistor mTR may serve to actually store weight recorded in each synaptic device 110.

The neural network device 100 may further include a plurality of lines for connecting the plurality of synaptic devices 110. For example, the neural network device 100 may further include a plurality of word lines $WL_1$, $WL_2$, $WL_3$, and $WL_4$, a plurality of selection word lines $SWL_1$, $SWL_2$, $SWL_3$, and $SWL_4$, a plurality of bit lines $BL_1$, $BL_2$, ..., and $BL_n$, and a plurality of source lines $SL_1$, $SL_2$, ..., and $SL_n$. In FIG. 3, only four word lines $WL_1$, $WL_2$, $WL_3$, and $WL_4$, and four selection word lines $SWL_1$, $SWL_2$, $SWLs$, and $SWL_4$ are, by way of example, illustrated, but in reality, a much larger number of word lines and selection word lines may be arranged.

Each of the plurality of word lines $WL_1$, $WL_2$, $WL_3$, and $WL_4$ may be electrically connected to the gate electrode of the memory transistor mTR of each of the plurality of synaptic devices 110 arranged along one row. Each of the plurality of selection word lines $SWL_1$, $SWL_2$, $SWL_3$, and $SWL_4$ may be electrically connected to the gate electrode of the select transistor sTR of each of the plurality of synaptic devices 110 arranged along one row. For example, the first word line $WL_1$ may be electrically connected to the gate electrode of the memory transistor mTR of each of the plurality of synaptic devices 110 arranged in a first row. The first selection word line $SWL_1$ may be electrically connected to the gate electrode of the select transistor sTR of each of the plurality of synaptic devices 110 arranged in the first row.

Each of the plurality of bit lines $BL_1$, $BL_2$, ..., and $BL_n$ may be electrically connected to the drain region of the memory transistor mTR of each of the plurality of synaptic devices 110 arranged along one column. Each of the plurality of source lines $SL_1$, $SL_2$, ..., and $SL_n$ may be electrically connected to the source region of the select transistor sTR of each of the plurality of synaptic devices 110 arranged along one column. For example, the first bit line $BL_1$ may be electrically connected to a drain region of the memory transistor mTR of each of the synaptic devices 110 arranged in the first column. The first source line $SL_1$ may be electrically connected to the source region of the select transistor sTR of each of the synaptic devices 110 arranged in the first column.

In FIG. 3, the plurality of word lines $WL_1$, $WL_2$, $WL_3$, and $WL_4$ and the plurality of selection word lines $SWL_1$, $SWL_2$, $SWL_3$, and $SWL_4$ are arranged in parallel with each other, the plurality of bit lines $BL_1$, $BL_2$, ..., and $BL_n$ and the plurality of source lines $SL_1$, $SL_2$, ..., and $SL_n$ are arranged in parallel with each other, and the plurality of word lines $WL_1$, $WL_2$, $WL_3$, and $WL_4$ and the plurality of selection word lines $SWL_1$, $SWL_2$, $SWL_3$, and $SWL_4$ perpendicularly cross the plurality of bit lines $BL_1$, $BL_2$, ..., and $BL_n$ and the plurality of source lines $SL_1$, $SL_2$, ..., and $SL_n$. However, this is only one example of various arrangements of the plurality of word lines $WL_1$, $WL_2$, $WL_3$, and $WL_4$, the plurality of selection word lines $SWL_1$, $SWL_2$, $SWL_3$, and $SWL_4$, the plurality of bit lines $BL_1$, $BL_2$, ..., and $BL_n$, and the plurality of source lines $SL_1$, $SL_2$, ..., and $SL_n$, and embodiments are not necessarily limited thereto.

Although not shown, the neural network device 100 may further include a logic circuit for controlling the operation of the plurality of synaptic devices 110. For example, the neural network device 100 may further include a driving circuit for providing voltages for the plurality of word lines $WL_1$, $WL_2$, $WL_3$, and $WL_4$, the plurality of selection word lines $SWL_1$, $SWL_2$, $SWL_3$, and $SWL_4$, and the plurality of source lines $SL_1$, $SL_2$, ..., and $SL_n$, an output circuit for outputting signals from the plurality of bit lines $BL_1$, $BL_2$, ..., and $BL_n$, a control circuit for controlling the operations of the driving circuit and the output circuit, a processor for processing the output signal, and the like.

The neural network device 100 may individually store weight values in the plurality of synaptic devices 110 in a learning operation by using the plurality of word lines $WL_1$, $WL_2$, $WL_3$, and $WL_4$, the plurality of selection word lines $SWL_1$, $SWL_2$, $SWL_3$, and $SWL_4$, the plurality of bit lines $BL_1$, $BL_2$, ..., and $BL_n$, and the plurality of source lines $SL_1$, $SL_2$, ..., and $SL_n$. and may perform an inference operation using weight values stored in the plurality of synaptic devices 110.

In the learning operation, for example, when a weight value is to be stored in one synaptic device 110 arranged in the first column of the first row, a program voltage is applied to the first word line $WL_1$, and a voltage greater than or equal to a threshold voltage of the select transistor sTR is applied to the first selection word line $SWL_1$. No voltage may be applied to the word lines $WL_2$, $WL_3$, and $WL_4$ and the selection word lines $SWL_2$, $SWL_3$, and $SWL_4$ of the remaining rows. Then, the select transistors sTR of the synaptic device 110 arranged in the first row may be turned on, and the select transistors sTR of the synaptic device 110 of the remaining rows may be turned off.

In addition, the first source line $SL_1$ in the first column may be grounded, and the first bit line $BL_1$ may be in a floating state. The source lines $SL_2$, ..., and $SL_n$ and the bit lines $BL_2$, ..., and $BL_n$ of the remaining columns may all be in a floating state. Alternatively, an inhibit voltage may be applied to the source lines $SL_2$, ..., and $SL_n$ of the remaining columns. The inhibit voltage may be, for example, the same voltage as the program voltage.

Then, a weight value may be stored in a gate insulating layer of the memory transistor mTR while a current flows from the gate electrode of the memory transistor mTR of the synaptic device 110 arranged in the first column of the first row to the source region thereof. The stored weight value may be determined according to the intensity of the program voltage. The program voltage is also applied to the gate electrode of the memory transistor mTR of the synaptic device 110 arranged in the remaining columns other than the first column in the first row, but since the drain region and the source region are in a floating state, or the drain region is in a floating state and a voltage equal to the program voltage is applied to the source region, current does not flow from the gate electrode to the source region or the drain region. Therefore, the weight value may not be stored in the gate insulating layer of the memory transistor mTR of the synaptic device 110 arranged in the remaining columns other than the first column in the first row.

After the weight value is stored in the synaptic device 110 arranged in the first column of the first row, the weight value may be stored in the synaptic device 110 arranged in the second column of the first row. In this case, the first source line $SL_1$ in the first column may be in a floating state or an inhibit voltage may be applied to the first source line $SL_1$, and the second source line $SL_2$ in the second column may be grounded. In this way, the weight values may be sequentially stored in the synaptic devices 110 column by column in the first row. After storing weight values in all synaptic devices 110 in the first row, a program voltage may be applied to the second word line $WL_2$ in the second row and a voltage higher than or equal to the threshold voltage of the select transistor sTR may be applied to the second selection word line $SWL_2$. In addition, weight values may be sequentially stored in the synaptic devices 110 column by column in the second row.

In the inference operation, the plurality of bit lines $BL_1$, $BL_2$, ..., and $BL_n$ may be grounded. In addition, a read voltage may be applied to all the word lines $WL_1$, $WL_2$, $WL_3$, and $WL_4$, and a voltage greater than or equal to the threshold voltage of the select transistor sTR may be applied to all the selection word lines $SWL_1$, $SWL_2$, $SWL_3$, and $SWL_4$. Different input signals or input voltages may be supplied to a plurality of source lines $SL_1$, $SL_2$, ..., and $SL_n$. For example, a first input voltage may be provided to the first source line $SL_1$, a second input voltage may be provided to the second source line $SL_2$, and an nth input voltage may be provided to the nth source line $SL_n$. Voltages provided to the plurality of source lines $SL_1$, $SL_2$, ..., and $SL_n$ may vary according to input data for performing an inference operation. In this case, the current flowing through any one of the plurality of bit lines $BL_1$, $BL_2$, ..., and $BL_n$ may be equal to the sum of the currents flowing through all the synaptic devices 110 connected to the bit line.

In another embodiment, input voltages may be sequentially provided one by one to the plurality of source lines $SL_1$, $SL_2$, ..., and $SL_n$ For example, a desired and/or alternatively predetermined input voltage may be supplied to the first source line $SL_1$, and the remaining source lines may be grounded or in a floating state. Then, a desired and/or alternatively predetermined input voltage may be supplied to the second source line $SL_2$, and the remaining source lines may be grounded or in a floating state.

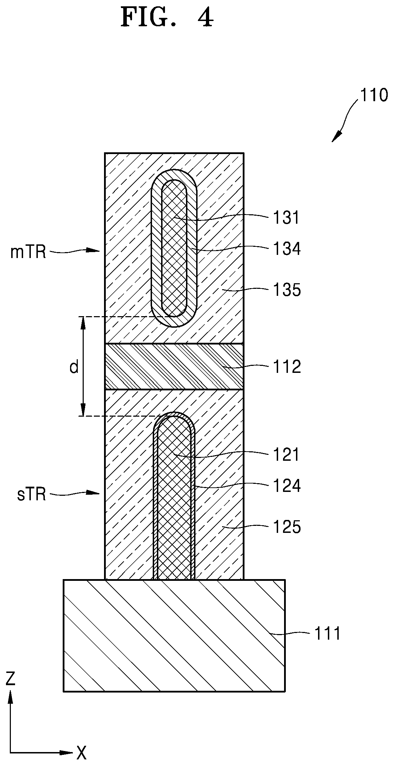

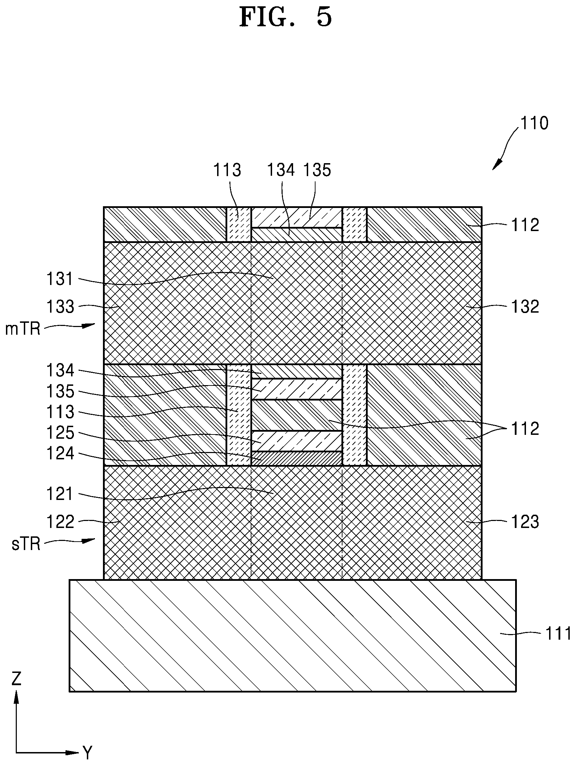

In addition, the memory transistor mTR and the select transistor sTR of the synaptic device 110 are arranged adjacent to each other in the horizontal direction in the circuit diagram of FIG. 3, but the memory transistor mTR and the select transistor sTR may be arranged in a vertical or thickness direction to reduce the area of the synaptic device 110 on a horizontal plane. In other words, the synaptic device 110 may include a vertically stacked transistor structure. FIGS. 4 and 5 are cross-sectional views illustrating a vertically stacked transistor structure of a synaptic device 110 according to an embodiment. In particular, FIG. 4 shows a cross-section along the X-Z plane, and FIG. 5 shows a cross-section along the Y-Z plane perpendicular to the X-Z plane.

Referring to FIGS. 4 and 5, a vertical stacked transistor structure of the synaptic device 110 may include a substrate 111, a select transistor sTR on the substrate 111, a memory transistor mTR stacked on the select transistor sTR in a vertical direction or a first direction (e.g., Z direction), and an insulating layer 112 between the select transistor sTR and the memory transistor mTR. The substrate 111 may be a silicon bulk substrate or a silicon-on-insulator (SOI) substrate. Alternatively, in another example, the substrate 111 may include another type of semiconductor substrate, such as a group III-V compound semiconductor substrate such as GaAs and GaP, besides silicon.

The select transistor sTR may include a channel 121, a source region 122, a drain region 123, a gate insulating layer 124, and a gate electrode 125.

The channel 121, the source region 122, and the drain region 123 may protrude from the upper surface of the substrate 111 in the first direction (e.g., the Z direction). In addition, the source region 122, the channel 121, and the drain region 123 may be arranged sequentially in the second direction (e.g., the Y direction) perpendicular to the first direction (e.g., the Z direction) and parallel to the upper surface of the substrate 111. In other words, the channel 121 may be disposed between the source region 122 and the drain region 123. The channel 121, the source region 122, and the drain region 123 may include, for example, at least one semiconductor material of a group IV semiconductor such as silicon (Si) and germanium (Ge), a group III-V compound semiconductor such as GaAs and GaP, an oxide semiconductor or a two-dimensional material semiconductor. The channel 121 may be doped with a first conductivity type, and the source region 122 and the drain region 123 may be doped with a second conductivity type that is electrically opposite to the first conductivity type. For example, the channel 121 may include a p-type semiconductor, the source region 122 and the drain region 123 may include an n-type semiconductor, or the channel 121 may include an n-type semiconductor, and the source region 122 and the drain region 123 may include a p-type semiconductor. The channel 121 may be doped at a relatively low concentration of about $10^{16}/cm^3$ to $10^{17}/cm^3$, and the source region 122 and the drain region 123 may be doped at a relatively high concentration of about $10^{19}/cm^3$ to $10^{21}/cm^3$.

The gate insulating layer 124 may be provided on the substrate 111 to surround the channel 121. For example, the gate insulating layer 124 may be provided to surround three surfaces of the channel 121, that is, both side surfaces and an upper surface. The gate insulating layer 124 may include at least one paraelectric material of silicon oxide ($SiO_2$), silicon nitride (SiN), aluminum oxide ($Al_2O_3$), titanium oxide ($TiO_2$), and zirconium oxide ($ZrO_2$), but is not limited thereto.

The gate electrode 125 may be provided on the substrate 111 to surround the gate insulating layer 124. For example, the gate electrode 125 may be provided to surround three surfaces of the gate insulating layer 124, that is, both side surfaces and an upper surface. The gate electrode 125 may include at least one conductive material of metal, metal nitride, metal carbide, polysilicon, and combinations thereof. For example, the metals may include aluminum (Al), tungsten (W), molybdenum (Mo), titanium (Ti), or tantalum (Ta), the metal nitrides may include titanium nitride (TiN) or tantalum nitride (TaN), and the metal carbides may include TiAlC, TaAlC, TiSiC or TaSiC.

An insulating layer 112 may be provided on an upper surface of the select transistor sTR, particularly, an upper surface of the gate electrode 125, an upper surface of the source region 122, and an upper surface of the drain region 123. The memory transistor mTR may be provided on the insulating layer 112. The memory transistor mTR may include a channel 131, a source region 132, a drain region 133, a gate insulating layer 134, and a gate electrode 135.

Materials of the channel 131, the source region 132, and the drain region 133 of the memory transistor mTR may be the same as materials of the channel 121, the source region 122, and the drain region 123 of the select transistor sTR described above. The drain region 133, the channel 131, and the source region 132 may be sequentially arranged in the second direction (e.g., the Y direction) in the memory transistor mTR. The channel 131, the source region 132, and the drain region 133 of the memory transistor mTR may be provided to face the channel 121, the drain region 123, and the source region 122 of the select transistor sTR while being spaced apart from each other in the first direction (Z direction). In other words, the channels 131 of the memory transistor mTR may face the channel 121 of the select transistor sTR while being spaced apart from each other in the first direction (Z direction), the source region 132 of the memory transistor mTR may face the drain region 123 of the select transistor sTR while being spaced apart from each other in the first direction (Z direction), and the drain region 133 of the memory transistor mTR may face the source region 122 of the select transistor sTR while being spaced apart from each other in the first direction (Z direction). A distance d between the channel 131 of the memory transistor mTR and the channel 121 of the select transistor sTR in the first direction (Z direction) may be about 3 nm to about 30 nm. The insulating layer 112 may be provided between the source region 132 of the memory transistor mTR and the drain region 123 of the select transistor sTR, facing each other, and between the drain region 133 of the memory transistor mTR and the source region 122 of the select transistor sTR, facing each other.

The gate insulating layer 134 may be provided to completely surround the channel 131. For example, the gate insulating layer 134 may be provided to surround four surfaces of the channel 131, that is, both side surfaces, a lower surface, and an upper surface. The gate insulating layer 134 may include a material capable of storing information.

For example, the gate insulating layer 134 may include a ferroelectric material having at least one of the fluorite structure, the perovskite structure, and the wurtzite structure described above. The ferroelectric having a fluoride structure may include, for example, hafnium oxide ($HfO_2$). For example, the hafnium oxide may be doped with at least one element of zirconium (Zr), lanthanum (La), aluminum (Al), silicon (Si), yttrium (Y), and gadolinium (Gd). Alternatively, the gate insulating layer 134 may include hafnium and zirconium in substantially the same element ratio, and additionally, at least one element among lanthanum (La), aluminum (Al), silicon (Si), yttrium (Y), and gadolinium (Gd) may be doped at a ratio of less than about 10 at%. In addition, the ferroelectric having a perovskite structure may include, for example, lead zirconate titanate (PZT). The ferroelectric having a wurtzite structure may include, for example, zinc oxide (ZnO) or aluminum nitride (AlN). The ferroelectric of such a wurtzite structure may be doped with, for example, at least one element of boron (B) and scandium (Sc).

In another example, the gate insulating layer 134 may store information in a charge trap manner. For example, the gate insulating layer 134 may include an insulating layer having a multilayer structure of oxide-nitride-oxide (ONO). For example, the gate insulating layer 134 may include a multilayer structure of $SiO_2/Si_3N_4/SiO_2$.

The gate electrode 135 of the memory transistor mTR may be provided to face the gate electrode 125 of the select transistor sTR while being spaced apart from each other in the first direction (Z direction). The insulating layer 112 may be provided between the gate electrode 135 of the memory transistor mTR and the gate electrode 125 of the select transistor sTR. The gate electrode 135 may be provided on the insulating layer 112 to completely surround the gate insulating layer 134. For example, the gate electrode 135 may be provided to surround four surfaces of the gate insulating layer 134, that is, both side surfaces, a lower surface, and an upper surface. The material of the gate electrode 135 of the memory transistor mTR may be the same as the material of the gate electrode 125 of the select transistor sTR described above.

The vertical stacked transistor structure of the synaptic device 110 may further include spacers 113 provided to contact both sides of the gate insulating layer 124 and both sides of the gate electrode 125 of the select transistor sTR in the second direction (e.g., the Y direction), and both sides of the gate insulating layer 134 and both sides of the gate electrode 135 of the memory transistor mTR in the second direction (e.g., the Y direction). The spacers 113 may extend in the first direction (e.g., the Z direction). In the process of manufacturing the vertically stacked transistor structure of the synaptic device 110 to be described later, the spacers 113 may serve to limit the positions of the gate insulating layer 124 and the gate electrode 125 of the select transistor sTR and the positions of the gate insulating layer 134 and the gate electrode 135 of the memory transistor mTR to be within a region facing the channel 121 of the select transistor sTR and the channel 131 of the memory transistor mTR in the second direction (e.g., the Y direction). The spacers 113 may include, for example, silicon nitride (SiN), but is not limited thereto.

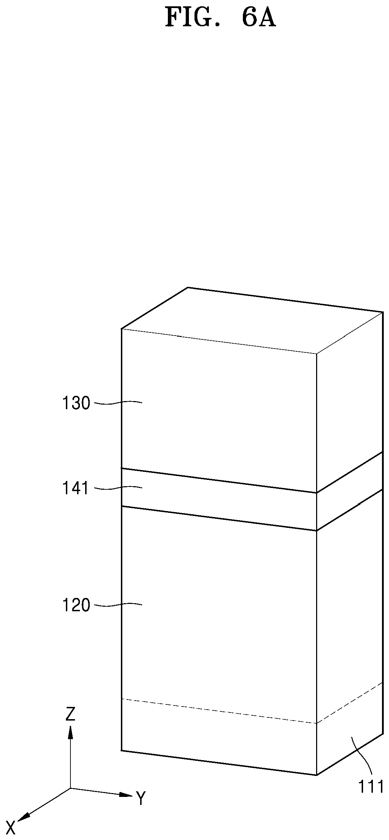

FIGS. 6A to 6K are perspective views illustrating a process of manufacturing a vertically stacked transistor structure of a synaptic device 110 according to an embodiment.

Referring to FIG. 6A, a first semiconductor layer 120, a sacrificial layer 141, and a second semiconductor layer 130 may be sequentially formed on an upper surface of a substrate 111. For example, the first semiconductor layer 120 may be grown on the upper surface of the substrate 111, the sacrificial layer 141 may be grown on the upper surface of the first semiconductor layer 120, and then the second semiconductor layer 130 may be grown on the upper surface of the sacrificial layer 141. The substrate 111 may be, for example, a silicon bulk substrate or an SOI substrate. In another example, the substrate 111 may include another type of semiconductor substrate, such as a group III-V compound semiconductor substrate such as GaAs and GaP, other than silicon. The first semiconductor layer 120 and the second semiconductor layer 130 may include one semiconductor material among silicon, germanium (Ge), and a compound semiconductor. The first semiconductor layer 120 and the second semiconductor layer 130 may include the same semiconductor material, but are not limited thereto and may include different semiconductor materials. The first semiconductor layer 120 and the second semiconductor layer 130 may be doped with a first conductivity type. The sacrificial layer 141 may include, for example, SiGe.

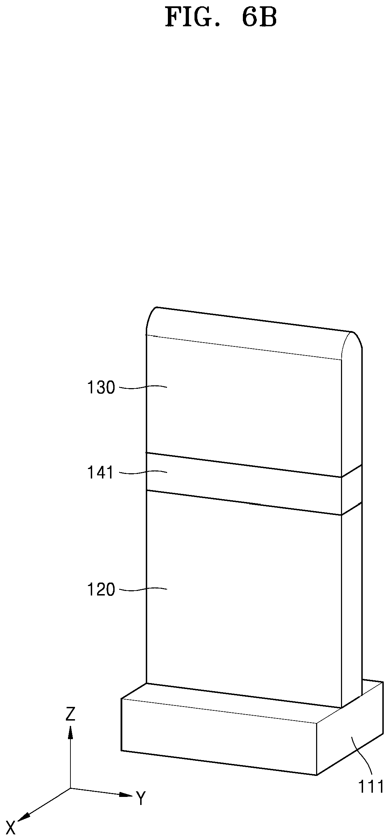

Referring to FIG. 6B, in the first semiconductor layer 120, the sacrificial layer 141, and the second semiconductor layer 130, the remaining area may be removed through etching, leaving only an area in which the select transistor sTR and the memory transistor mTR shown in FIGS. 4 and 5 are to be formed. In other words, a shallow trench isolation (STI) may be formed around the region in which the select transistor sTR and the memory transistor mTR are to be formed in a third direction (e.g., X direction) perpendicular to the first direction (e.g., Z direction) and the second direction (e.g., Y direction) and parallel to the upper surface of the substrate 111. Although FIG. 6B illustrates only one region in which one select transistor sTR and one memory transistor mTR are to be formed for convenience, in reality, a plurality of regions in which a plurality of select transistors sTR and a plurality of memory transistors mTR are to be formed and a plurality of STIs may be alternately arranged in the third direction (e.g., X direction) and on the substrate 111.

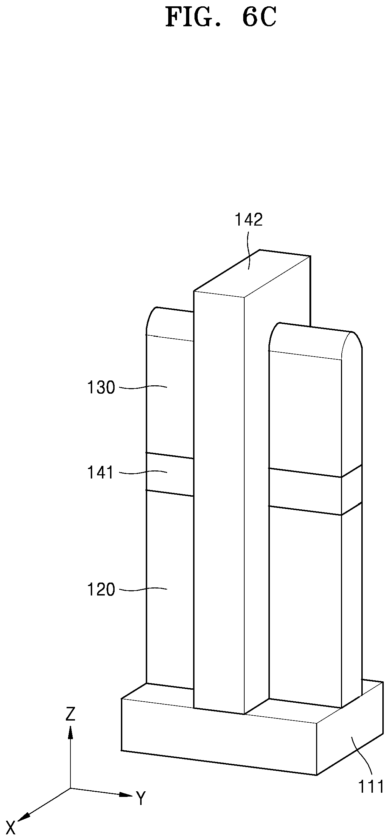

Referring to FIG. 6C, a dummy gate 142 may be formed to surround a partial region of the first semiconductor layer 120 and a partial region of the second semiconductor layer 130. The dummy gate 142 may be formed to completely cover the upper surface of the second semiconductor layer 130 in a cross section along the third direction (e.g., X direction). The dummy gate 142 may include, for example, polysilicon (p-Si), but is not limited thereto. For example, the dummy gate 142 may be formed by forming a polysilicon on the substrate 111 to completely cover the first semiconductor layer 120, the sacrificial layer 141, and the second semiconductor layer 130, and then removing, through etching, a portion of the polysilicon covering both sides of each of the first semiconductor layer 120, the sacrificial layer 141, and the second semiconductor layer 130 in the second direction (e.g., the Y direction). Therefore, the dummy gate 142 may be provided to surround a central portion of each of the first semiconductor layer 120, the sacrificial layer 141, and the second semiconductor layer 130 in the second direction (e.g., the Y direction). A partial region of the first semiconductor layer 120 surrounded by the dummy gate 142 may be the channel 121 of the select transistor sTR shown in FIGS. 4 and 5, and a partial region of the second semiconductor layer 130 surrounded by the dummy gate 142 may be the channel 131 of the memory transistor mTR shown in FIGS. 4 and 5.

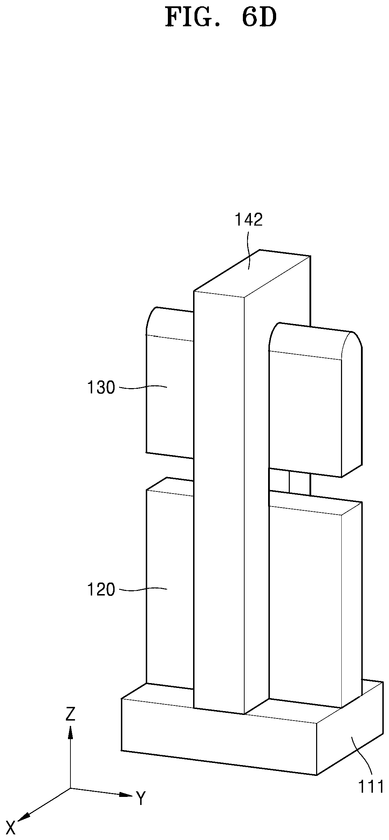

Referring to FIG. 6D, only the sacrificial layer 141 may be selectively removed through etching. Then, an empty space may be formed between the first semiconductor layer 120 and the second semiconductor layer 130 in the first direction (e.g., the Z direction). The first semiconductor layer 120 and the second semiconductor layer 130 may be supported by the dummy gate 142.

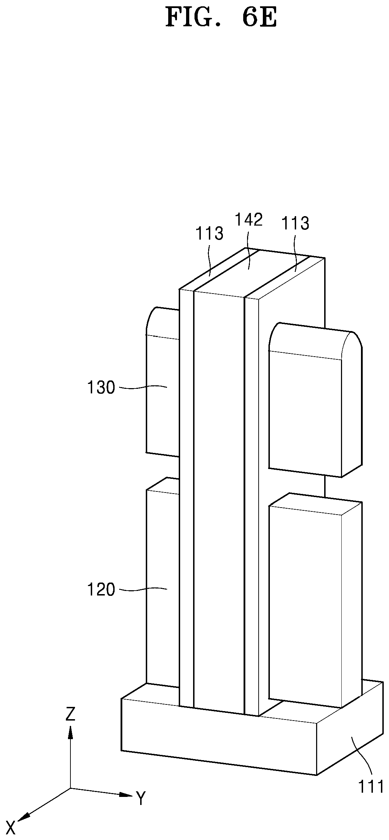

Referring to FIG. 6E, spacers 113 may be formed on both sides of the dummy gate 142 in the second direction (e.g., the Y direction), respectively.

The spacers 113 may extend from the upper surface of the substrate 111 to the upper surface of the second semiconductor layer 130 in the first direction (e.g., the Z direction) so as to surround the first semiconductor layer 120 and the second semiconductor layer 130 on both sides of the dummy gate 142. In addition, the spacers 113 may be provided in spaces between the first semiconductor layer 120 and the second semiconductor layer 130. Therefore, the spacers 113 may be provided to surround three surfaces of the first semiconductor layer 120, e.g., both sides and an upper surface, and surround four surfaces of the second semiconductor layer 130, e.g., both side surfaces, a lower surface, and an upper surface. A width of each of the spacers 113 in the second direction (e.g., the Y direction) may be smaller than a width of the first semiconductor layer 120 and a width of the second semiconductor layer 130 in the second direction (e.g., the Y direction). Therefore, the first semiconductor layer 120 and the second semiconductor layer 130 may protrude from the spacers 113 in the second direction (e.g., the Y direction), respectively. The spacers 113 include, but not limited to, silicon nitride, for example.

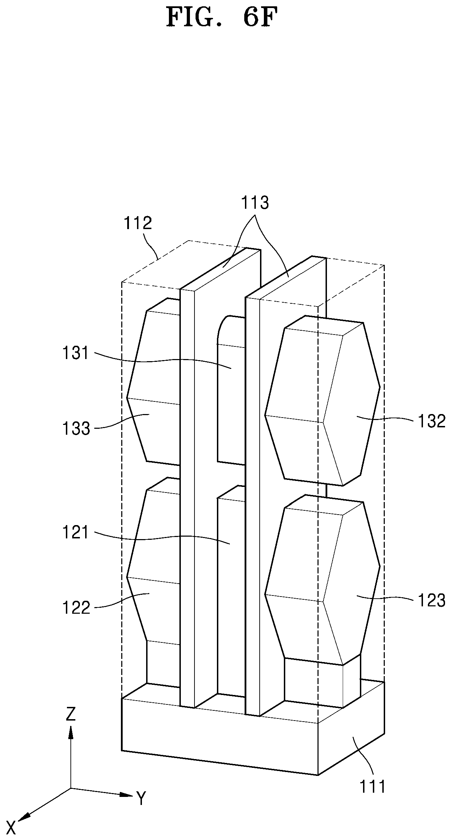

Referring to FIG. 6F, the source region 122 and the drain region 123 of the select transistor sTR and the source region 132 and the drain region 133 of the memory transistor mTR, shown in FIGS. 4 and 5 may be formed by doping the first semiconductor layer 120 and the second semiconductor layer 130 protruding from the respective spacers 113 in the second direction (e.g., the Y direction) in a second conductivity type that is electrically opposite to the first conductivity type. Alternatively, after the first semiconductor layer 120 and the second semiconductor layer 130 respectively protruding from the spacers 113 are removed in the second direction (e.g., the Y direction), semiconductor layers doped with the second conductivity type are further grown in the second direction (e.g., the Y direction) from the first semiconductor layer 120 and the second semiconductor layer 130 remaining between the two spacers 113, and thus, the source region 122 and the drain region 123 of the select transistor sTR and the source region 132 and the drain region 133 of the memory transistor mTR may be formed.

Then, an insulating layer 112 may be formed on one side surface of each of the two spacers 113 to completely cover the source region 122 and the drain region 123 of the select transistor sTR and the source region 132 and the drain region 133 of the memory transistor mTR. The insulating layer 112 may include, for example, silicon oxide ($SiO_2$), but is not limited thereto. After the insulating layers 112 are formed, the dummy gate 142 between the two spacers 113 may be removed. Then, the channel 121 of the select transistor sTR and the channel 131 of the memory transistor mTR may be exposed between the two spacers 113 in the second direction (e.g., the Y direction).

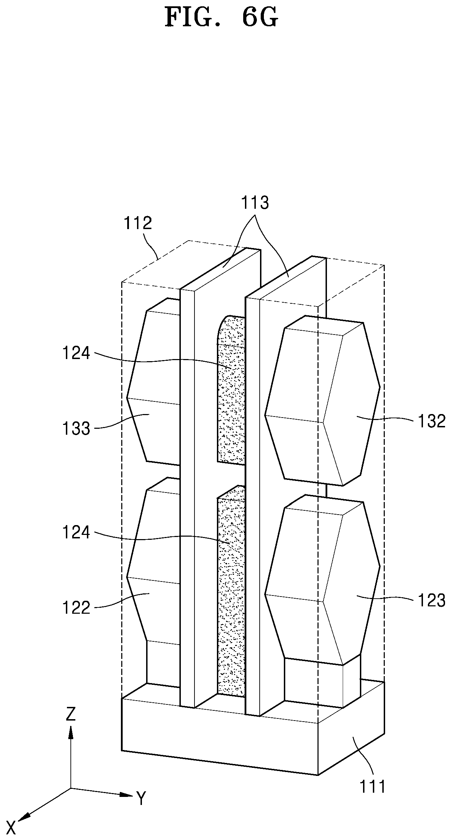

Referring to FIG. 6G, a gate insulating layer 124 may be formed between the two spacers 113 in the second direction (e.g., the Y direction) to cover the surface of the channel 121 of the select transistor sTR. For example, the gate insulating layer 124 may include at least one paraelectric material of silicon oxide ($SiO_2$), silicon nitride (SiN), aluminum oxide ($Al_2O_3$), titanium oxide ($TiO_2$), and zirconium oxide ($ZrO_2$), but is not necessarily limited thereto. In this case, such a gate insulating layer 124 may also be formed on a surface of the channel 131 of the memory transistor mTR. For example, four surfaces of the channel 131 of the memory transistor mTR, that is, both side surfaces, a lower surface, and an upper surface, may be surrounded by the gate insulating layer 124 of the select transistor sTR.

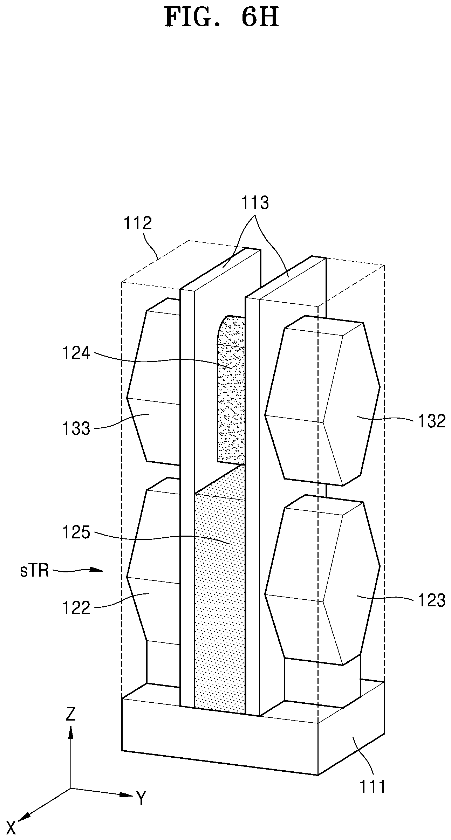

Referring to FIG. 6H, a gate electrode 125 may be formed between the two spacers 113 in the second direction (e.g., the Y direction) to cover the gate insulating layer 124 of the select transistor sTR. For example, after filling a conductive material between two spacers 113, the upper conductive material may be removed through etching so that the gate insulating layer 124 formed on the surface of the channel 131 of the memory transistor mTR is exposed. Then, the select transistor sTR may be completed. The gate electrode 125 may surround three surfaces of the gate insulating layer 124 of the select transistor sTR, that is, both side surfaces and an upper surface. The gate electrode 125 may include, for example, at least one conductive material of metal, metal nitride, metal carbide, polysilicon, and combinations thereof.

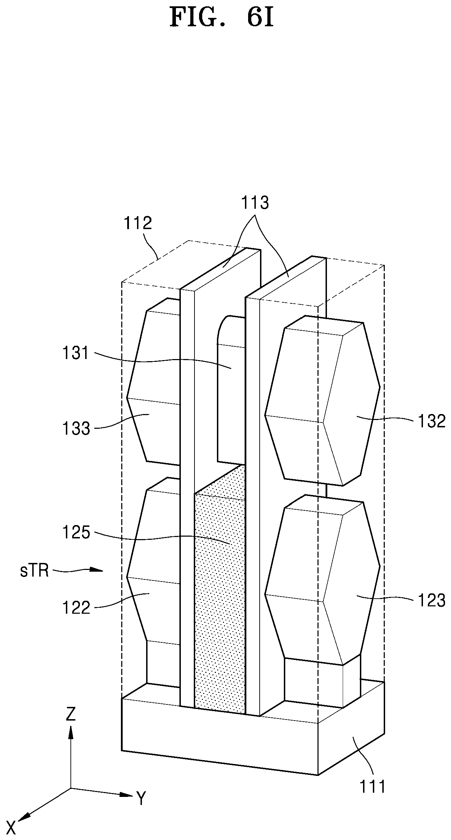

Referring to FIG. 6I, the gate insulating layer 124 formed on the surface of the channel 131 of the memory transistor mTR may be removed through etching. Then, the channel 131 of the memory transistor mTR may be exposed to the outside.

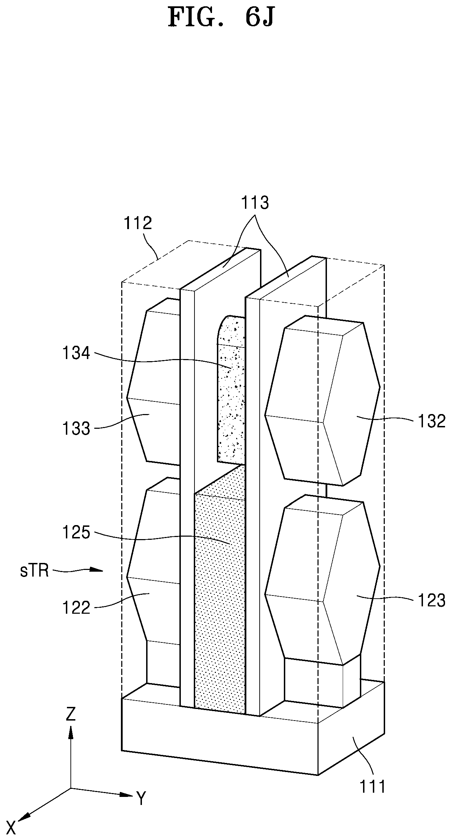

Referring to FIG. 6J, a gate insulating layer 134 may be formed between the two spacers 113 in the second direction (e.g., the Y direction) to cover the surface of the channel 131 of the memory transistor mTR. The gate insulating layer 134 may be provided to completely surround the channel 131. For example, the gate insulating layer 134 may be formed to surround four surfaces of the channel 131, that is, both side surfaces, a lower surface, and an upper surface. The gate insulating layer 134 may include a material capable of storing information. For example, the gate insulating layer 134 may include a ferroelectric material or may include a charge trap material having an ONO multilayer structure.

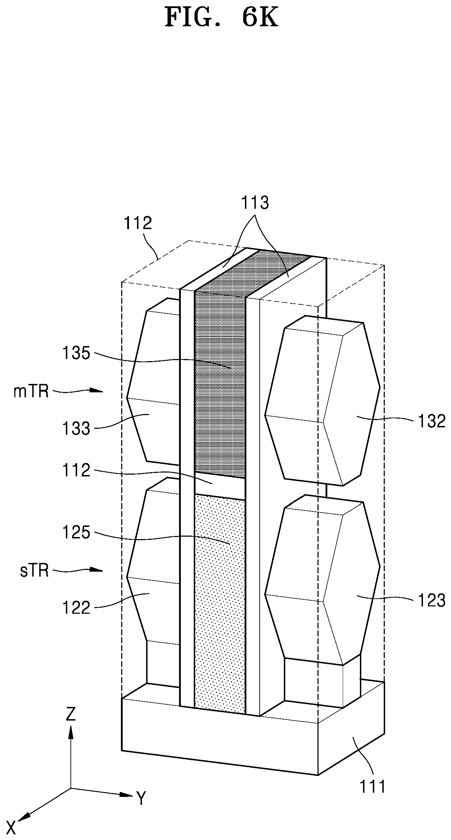

Referring to FIG. 6K, an insulating layer 112 may be formed on an upper surface of the gate electrode 125 of the select transistor sTR. Then, a gate electrode 135 may be formed between the two spacers 113 in the second direction (e.g., the Y direction) to cover the gate insulating layer 134 of the memory transistor mTR. The gate electrode 135 may surround four surfaces of the gate insulating layer 134 of the memory transistor mTR, that is, both side surfaces, a lower surface, and an upper surface. In this way, a vertical stacked transistor structure of one synaptic device 110 including a stacked transistor structure in which the memory transistor mTR is stacked on the select transistor sTR in the first direction (e.g., the Z direction) may be completed.

Since the synaptic device 110 including the vertically stacked transistor structure described above may have one of a plurality of discrete weight values distinguished from each other according to the intensity of a program voltage applied thereto, in-memory computing may be implemented. In addition, the synaptic device 110 according to an embodiment may occupy a relatively small area on a horizontal plane because the synaptic device 110 has a vertically stacked transistor structure in which a select transistor sTR and a memory transistor mTR are stacked in a vertical direction. Accordingly, the neural network device 100 including the synaptic device 110 according to an embodiment may be manufactured with a relatively improved degree of integration.

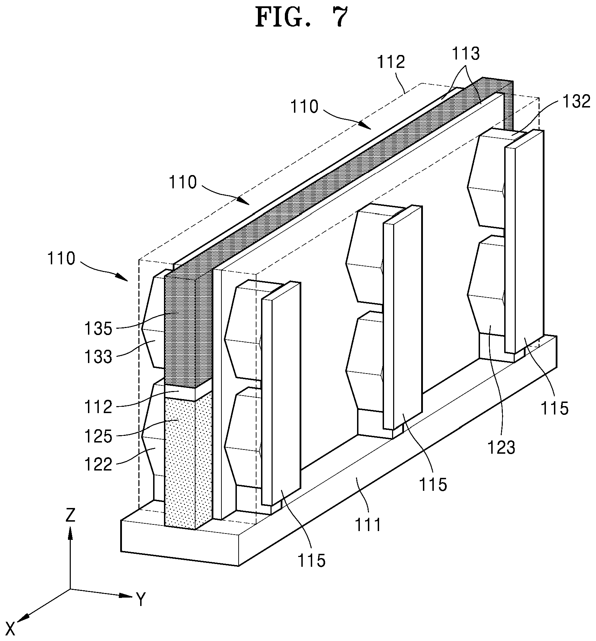

FIGS. 6A to 6K illustrate a process of manufacturing a vertically stacked transistor structure of one synaptic device 110 including one select transistor sTR and one memory transistor mTR for convenience, but a plurality of vertically stacked transistor structures of a plurality of synaptic devices 110 arranged in two dimensions along a plurality of rows and a plurality of columns may be simultaneously formed on the substrate 111. FIG. 7 is a perspective view illustrating a plurality of vertically stacked transistor structures of a plurality of synaptic devices 110 arranged along one row. Referring to FIG. 7, in one row, a plurality of vertically stacked transistor structures of the plurality of synaptic devices 110 may be arranged to be spaced apart from each other in the third direction (e.g., X direction). Accordingly, the plurality of select transistors sTR may be arranged to be spaced apart from each other in the third direction (e.g., X direction), and the plurality of memory transistors mTR may be arranged to be spaced apart from each other in the third direction (e.g., X direction). Vertical stacked transistor structures of two adjacent synaptic devices 110 may be separated from each other by STI, and an insulating layer 112 may be filled in the STI.

In addition, one gate electrode 125 for a plurality of select transistors sTR may extend in the third direction (e.g., X direction). In addition, one gate electrode 135 for a plurality of memory transistors mTR may extend along the third direction (e.g., X direction). In this case, it may be considered that one gate electrode 125 is provided in common for a plurality of select transistors sTR of a plurality of synaptic devices 110 arranged along one row, and one gate electrode 135 is provided in common for a plurality of memory transistors mTR of a plurality of synaptic devices 110 arranged along one row. In addition, in this case, the gate electrode 125 may be a selected word line shown in FIG. 3, and the gate electrode 135 may be a word line shown in FIG. 3.

In addition, each of the plurality of vertically stacked transistor structures of the plurality of synaptic devices 110 may further include a conductor 115 configured to electrically connect the drain region 123 of the select transistor sTR and the source region 132 of the memory transistor mTR. The conductor 115 may extend in the first direction (e.g., the Z direction) to contact the drain region 123 of the select transistor sTR and the source region 132 of the memory transistor mTR. For example, a hole may be formed by etching a portion of the insulating layer 112 in contact with the drain region 123 of the select transistor sTR and the source region 132 of the memory transistor mTR, and then filling the hole with a conductive material, to thereby form the conductor 115.

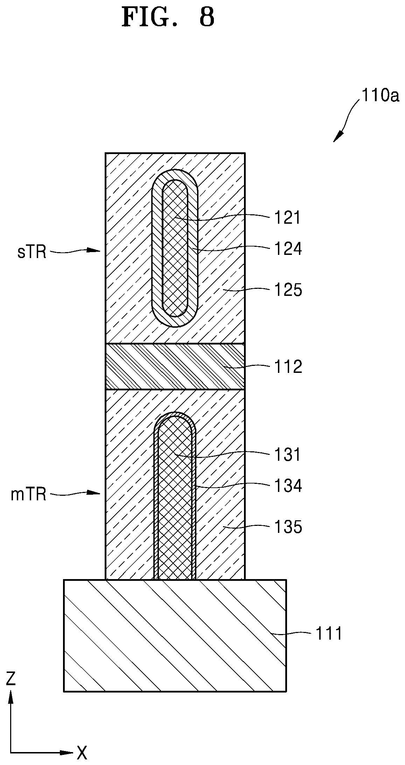

In example embodiments described above, the select transistor sTR may be on the substrate 111 and the memory transistor mTR may be on the select transistor sTR, but embodiments are not necessarily limited thereto. FIG. 8 is a cross-sectional view illustrating a vertically stacked transistor structure of a synaptic device according to another embodiment. Referring to FIG. 8, a vertical stacked transistor structure of a synaptic device 110a may include a substrate 111, a memory transistor mTR on the substrate 111, a select transistor sTR stacked on the memory transistor mTR in a vertical direction or a first direction (e.g., Z direction), and an insulating layer 112 between the memory transistor mTR and the select transistor sTR.

In the examples of FIGS. 4 and 8, a transistor provided directly over the substrate 111 may be referred to as a "first transistor", and a transistor provided over the first transistor in the first direction (e.g., Z direction) may be referred to as a "second transistor". The first transistor may include a first channel, a first source region, a first drain region, a first gate insulating layer, and a first gate electrode. The second transistor may include a second channel, a second source region, a second drain region, a second gate insulating layer, and a second gate electrode. One of the first gate insulating layer and the second gate insulating layer may include a single layer of a paraelectric material, and the other may include a data recording material such as a ferroelectric material or a charge trap material.

In an embodiment shown in FIG. 4, the first transistor may be a select transistor sTR and the second transistor may be a memory transistor mTR. In this case, the first channel, the first source region, the first drain region, the first gate insulating layer, and the first gate electrode are the channel 121, the source region 122, the drain region 123, the gate insulating layer 124, and the gate electrode 125 of the select transistor sTR, respectively, and the second channel, the second source region, the second drain region, the second gate insulating layer, and the second gate electrode may be the channel 131, the source region 132, the drain region 133, the gate insulating layer 134, and the gate electrode 135 of the memory transistor mTR, respectively. In addition, the first gate insulating layer may include a single layer of a paraelectric material, and the second gate insulating layer may include a data recording material. For example, the second gate insulating layer may include a ferroelectric material or may include a charge trap material having an ONO multilayer structure.

In addition, in the embodiment shown in FIG. 8, the first transistor may be a memory transistor mTR and the second transistor may be a select transistor sTR. In this case, the first channel, the first source region, the first drain region, the first gate insulating layer, and the first gate electrode may be the channel 131, the source region 132, the drain region 133, the gate insulating layer 134, and the gate electrode 135 of the memory transistor mTR, respectively, and the second channel, the second source region, the second drain region, the second gate insulating layer, and the second gate electrode may be the channel 121, the source region 122, the drain region 123, the gate insulating layer 124, and the gate electrode 125 of the select transistor sTR, respectively. In addition, the first gate insulating layer may include a data recording material, and the second gate insulating layer may include a single layer of a paraelectric material. For example, the first gate insulating layer may include a ferroelectric material or may include a charge trap material having an ONO multilayer structure.

In the embodiments shown in FIGS. 4 and 8, the first transistor provided directly above the substrate 111 is a fin field-effect transistor (FinFET) in which three surfaces of the first channel are surrounded by the first gate insulating layer and the first gate electrode, and the second transistor stacked on the first transistor is a gate-all-around (GAA) FET in which four surfaces of the second channel are surrounded by the second gate insulating layer and the second gate electrode. However, this is just an example, and embodiments are not necessarily limited thereto.

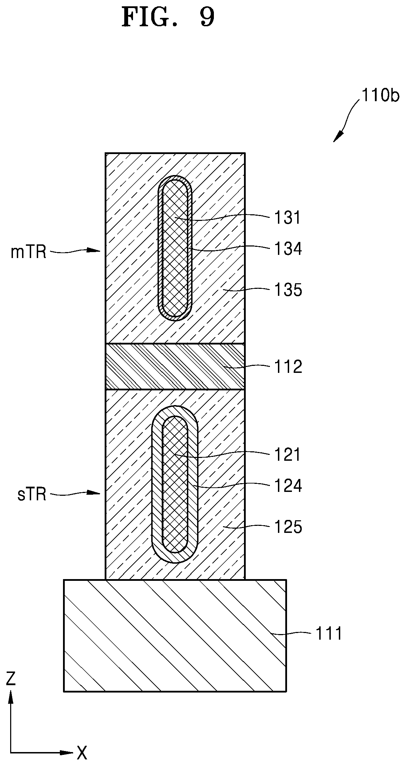

FIG. 9 is a cross-sectional view illustrating a vertically stacked transistor structure of a synaptic device according to another embodiment. Referring to FIG. 9, a vertical stacked transistor structure of the synaptic device 110b may include a substrate 111, a select transistor sTR on the substrate 111, a memory transistor mTR stacked on the select transistor sTR in a vertical direction or a first direction (e.g., Z direction), and an insulating layer 112 between the select transistor sTR and the memory transistor mTR. The gate insulating layer 124 of the select transistor sTR may be provided to surround four surfaces of the channel 121, that is, both side surfaces, a lower surface, and an upper surface. In addition, the gate electrode 125 of the select transistor sTR may be provided to surround the four surfaces of the gate insulating layer 124.

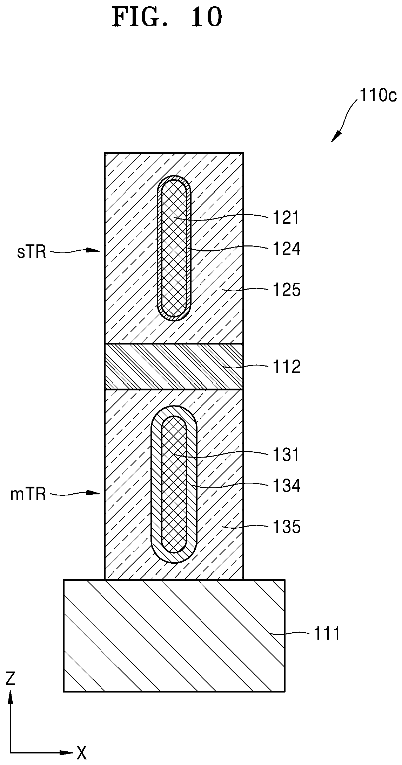

FIG. 10 is a cross-sectional view illustrating a vertically stacked transistor structure of a synaptic device according to another embodiment. Referring to FIG. 10, a vertical stacked transistor structure of a synaptic device 110c may include a substrate 111, a memory transistor mTR on the substrate 111, a select transistor sTR stacked on the memory transistor mTR in a vertical direction or a first direction (e.g., Z direction), and an insulating layer 112 between the memory transistor mTR and the select transistor sTR. The gate insulating layer 134 of the memory transistor mTR may be provided to surround four surfaces of the channel 131, that is, both side surfaces, a lower surface, and an upper surface. In addition, the gate electrode 135 of the memory transistor mTR may be provided to surround the four surfaces of the gate insulating layer 134.

Thus, in the embodiments shown in FIGS. 9 and 10, four surfaces of the first channel of the first transistor are surrounded by the first gate insulating layer and the first gate electrode, and four surfaces of the second channel of the second transistor are surrounded by the second gate insulating layer and the second gate electrode. In this regard, in the embodiments shown in FIGS. 9 and 10, both the first transistor provided directly on the substrate 111 and the second transistor stacked on the first transistor may be GAA FETs.

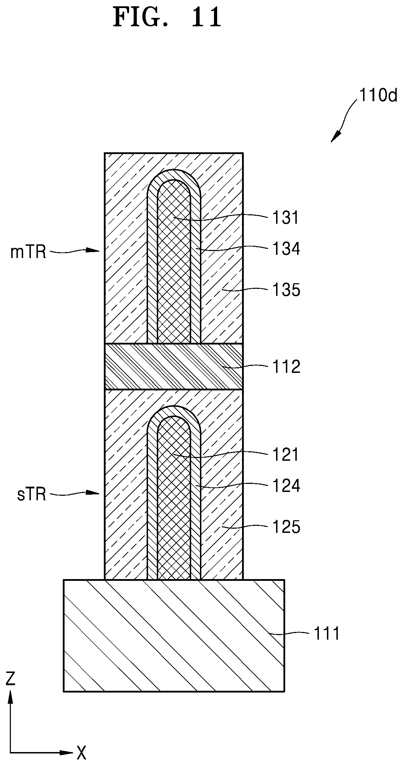

FIG. 11 is a cross-sectional view illustrating a vertically stacked transistor structure of a synaptic device according to another embodiment. Referring to FIG. 11, a vertical stacked transistor structure of the synaptic device 110d may include a substrate 111, a select transistor sTR on the substrate 111, a memory transistor mTR stacked on the select transistor sTR in a vertical direction or a first direction (e.g., Z direction), and an insulating layer 112 between the select transistor sTR and the memory transistor mTR. The gate insulating layer 134 of the memory transistor mTR may be provided to surround three surfaces of the channel 131, that is, both side surfaces and an upper surface. In addition, the gate electrode 135 of the memory transistor mTR may be provided to surround three surfaces of the gate insulating layer 134, that is, both side surfaces and an upper surface.

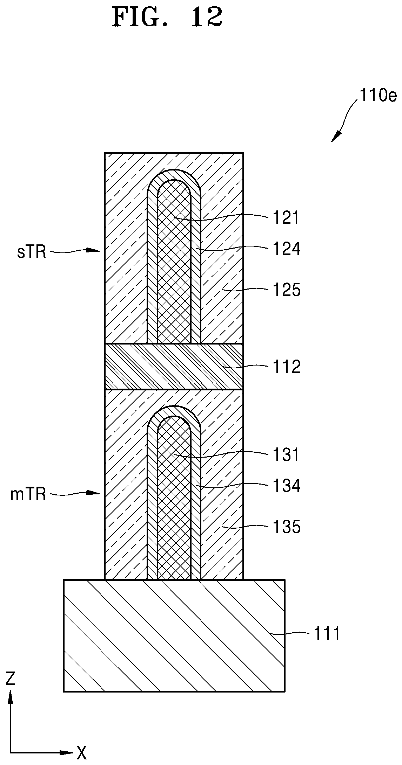

FIG. 12 is a cross-sectional view illustrating a vertically stacked transistor structure of a synaptic device according to another embodiment. Referring to FIG. 12, a vertical stacked transistor structure of a synaptic device 110e may include a substrate 111, a memory transistor mTR on the substrate 111, a select transistor sTR stacked on the memory transistor mTR in a vertical direction or a first direction (e.g., Z direction), and an insulating layer 112 between the memory transistor mTR and the select transistor sTR. The gate insulating layer 124 of the select transistor sTR may be provided to surround three surfaces of the channel 121, that is, both side surfaces and an upper surface. In addition, the gate electrode 125 of the select transistor sTR may be provided to surround three surfaces of the gate insulating layer 124, that is, both side surfaces and an upper surface.

Thus, in the embodiments shown in FIGS. 11 and 12, three surfaces of the first channel of the first transistor are surrounded by the first gate insulating layer and the first gate electrode, and three surfaces of the second channel of the second transistor are surrounded by the second gate insulating layer and the second gate electrode. In this regard, in the embodiments shown in FIGS. 11 and 12, both the first transistor provided directly on the substrate 111 and the second transistor stacked on the first transistor may be FinFETs.

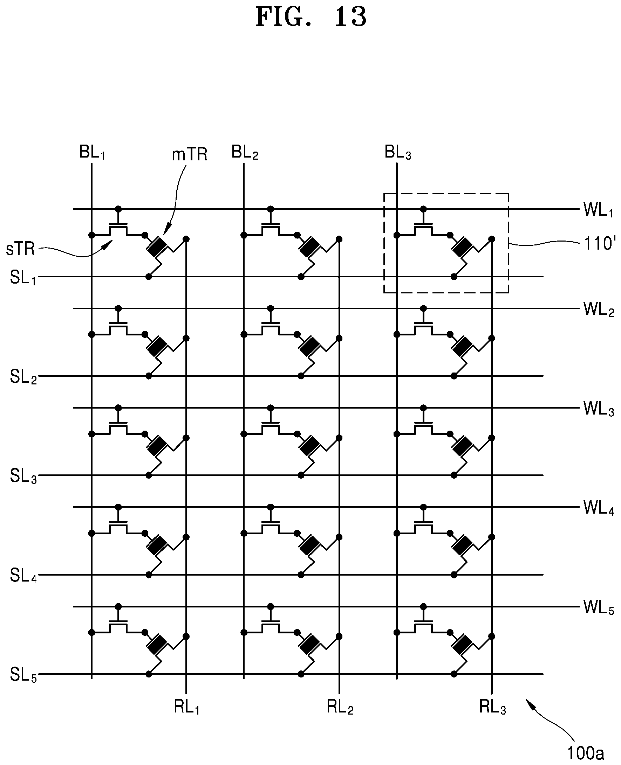

In addition, in the synaptic device 110 of the neural network device 100 shown in FIG. 3, the select transistor sTR and the memory transistor mTR may be connected in series, but a neural network device may be implemented in a different structure. FIG. 13 is a circuit diagram schematically illustrating a structure of a neural network device according to another embodiment. Referring to FIG. 13, a neural network device 100a may include an array of a plurality of synaptic devices 110' arranged in two dimensions along a plurality of rows and a plurality of columns. Each of the plurality of synaptic devices 110' may include one select transistor sTR and one memory transistor mTR. In each of the plurality of synaptic devices 110', the gate electrode of the memory transistor mTR may be electrically connected to the drain region of the select transistor sTR.

The neural network device 100a may also include a plurality of word lines $WL_1$, $WL_2$, $WL_3$, $WL_4$, and $WL_5$, a plurality of bit lines $BL_1$, $BL_2$, and $BL_3$, a plurality of source lines $SL_1$, $SL_2$, $SL_3$, $SL_4$, and $SL_5$, and a plurality of read lines $RL_1$, $RL_2$, and $RL_3$. The gate electrode of the select transistor sTR may be electrically connected to one corresponding word line among the plurality of word lines $WL_1$, $WL_2$, $WL_3$, $WL_4$, and $WL_5$, and the source region may be electrically connected to one corresponding bit line among the plurality of bit lines $BL_1$, $BL_2$, and $BL_3$. The source region of the memory transistor mTR may be electrically connected to one corresponding source line among the plurality of source lines $SL_1$, $SL_2$, $SL_3$, $SL_4$, and $SL_5$, and the drain region may be electrically connected to one corresponding read line among the plurality of read lines $RL_1$, $RL_2$, and $RL_3$. In addition, although not shown, the neural network device 100a may further include a logic circuit for controlling the operation of the plurality of synaptic devices 110'.

In the learning operation, for example, when a weight value is to be stored in one synaptic device 110' arranged in the first column of the first row, a voltage greater than or equal to the threshold voltage of the select transistor sTR is applied to the first word line $WL_1$. Then, the select transistors sTR of the synaptic device 110' arranged in the first row may be turned on, and the select transistors sTR of the synaptic device 110' of the remaining rows may be turned off.

In addition, a program voltage may be applied to the first bit line $BL_1$, the first source line $SL_1$ may be grounded, and the first read line $RL_1$ may be in a floating state. The bit lines $BL_2$ and $BL_3$ of the remaining columns, the read lines $RL_2$ and $RL_3$, and the source lines $SL_2$, $SL_3$, $SL_4$, and $SL_5$ of the remaining rows may all be in a floating state. Then, a weight value may be stored in the gate insulating layer of the memory transistor mTR while a current flows from the gate electrode of the memory transistor mTR of the synaptic device 110' arranged in the first column of the first row to the source region thereof. The stored weight value may be determined according to the intensity of the program voltage. The weight value of the gate insulating layer of the memory transistor mTR of the remaining synaptic device 110' may not be changed.

After the weight value is stored in the synaptic device 110' arranged in the first column of the first row, the weight value may be stored in the synaptic device 110' arranged in the second column of the first row. In this case, a program voltage may be applied to the second bit line $BL_2$ in the second column, and the first bit line $BL_1$ may be in a floating state. In this way, the weight values may be sequentially stored in the synaptic devices 110' column by column in the first row. After the weight values are stored in all the synaptic devices 110' in the first row, a voltage greater than or equal to the threshold voltage of the select transistor sTR is applied to the second word line $WL_2$, and the second source line $SL_2$ may be grounded. In addition, weight values may be sequentially stored in the synaptic devices 110' column by column in the second row.

In the inference operation, a voltage greater than or equal to a threshold voltage of the select transistor sTR may be applied to all the word lines $WL_1$, $WL_2$, $WL_3$, $WL_4$, and $WL_5$, and a read voltage may be applied to all the bit lines $BL_1$, $BL_2$, and $BL_3$. In addition, all the read lines $RL_1$, $RL_2$, and $RL_3$ may be grounded. Different input signals or input voltages may be supplied to the plurality of source lines $SL_1$, $SL_2$, $SL_5$, $SL_4$, and $SL_5$. Voltages provided to the plurality of source lines $SL_1$, $SL_2$, $SL_3$, $SL_4$, and $SL_5$ may vary according to input data for performing an inference operation. In this case, the current flowing through any one of the plurality of read lines $RL_1$, $RL_2$, and $RL_3$ may be equal to the sum of the currents flowing through all the synaptic devices 110' connected to the read line.

In another embodiment, read voltages may be sequentially provided to the plurality of bit lines $BL_1$, $BL_2$, and $BL_3$. For example, a read voltage may be supplied to the first bit line $BL_1$ and the remaining bit lines may be grounded or in a floating state. Then, a read voltage may be supplied to the second bit line $BL_2$ and the remaining bit lines may be grounded or in a floating state. In this way, the inference operation may be performed column by column.

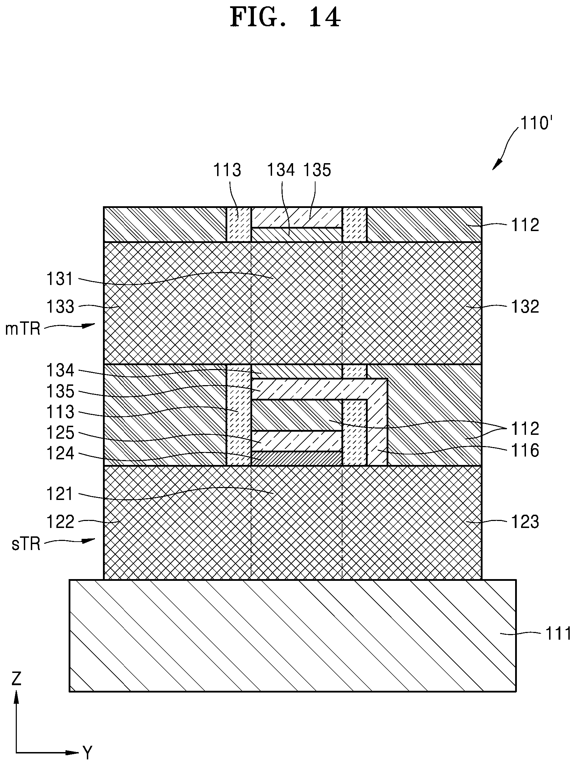

In addition, FIG. 14 is a cross-sectional view illustrating a vertically stacked transistor structure of a synaptic device 110' included in the neural network device 100a illustrated in FIG. 13. Referring to FIG. 14, the basic configuration of the vertical stacked transistor structure of the synaptic device 110' may be substantially the same as the configuration of the vertical stacked transistor structure of the synaptic device 110 shown in FIG. 5. The vertically stacked transistor structure of the synaptic device 110' shown in FIG. 14 may further include a conductor 116 provided to electrically connect the drain region 123 of the select transistor sTR and the gate electrode 135 of the memory transistor mTR. The conductor 116 may extend from the drain region 123 of the select transistor sTR to the same level as the level of the gate electrode 135 of the memory transistor mTR in the first direction (e.g., the Z direction) along the surface of the spacer 113. The gate electrode 135 of the memory transistor mTR may extend to pass the spacer 113 in the second direction (e.g., the Y direction) to be electrically connected to the conductor 116. Alternatively, the conductor 116 may extend to pass the spacer 113 in the second direction (e.g., the Y direction) to be electrically connected to the gate electrode 135 of the memory transistor mTR. Since the remaining configuration of the vertically stacked transistor structure of the synaptic device 110' shown in FIG. 14 is the same as the remaining configuration of the vertically stacked transistor structure of the synaptic device 110 shown in FIG. 5, a detailed description thereof is omitted.

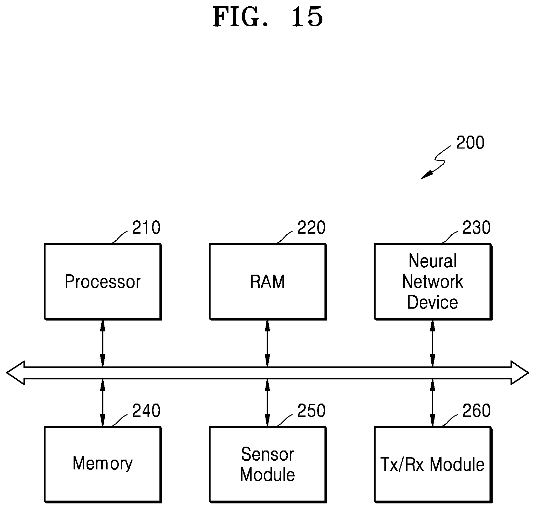

FIG. 15 is a schematic block diagram showing an example configuration of an electronic apparatus including a neural network device. Referring to FIG. 15, the electronic apparatus 200 may analyze input data in real time based on a neural network to extract valid information, determine a situation based on the extracted information, or control configurations of a device equipped with the electronic apparatus 200. For example, the electronic apparatus 200 may be applied to a robot device such as a drone, an advanced driver assistance system (ADAS), or the like, a smart TV, a smartphone, a medical device, a mobile device, an image display device, a measurement device, and an IoT device, and the like, and may be mounted on at least one of various types of devices.

The electronic apparatus 200 may include a processor 210, a random access memory (RAM) 220, a neural network device 230, a memory 240, a sensor module 250, and a communication (Tx/Rx) module 260. The electronic apparatus 200 may further include an input/output module, a security module, a power control device, and the like. Some of the hardware components of the electronic apparatus 200 may be mounted on at least one semiconductor chip.

The processor 210 may control the overall operation of the electronic apparatus 200. The processor 210 may include one processor core or a plurality of processor cores (e.g., Multi-Core). The processor 210 may process or execute programs and/or data stored in the memory 240. In some embodiments, the processor 210 may control the function of the neural network device 230 by executing programs stored in the memory 240. The processor 210 may be implemented as a central processing unit (CPU), a graphics processing unit (GPU), an application processor (AP), or the like.

The RAM 220 may temporarily store programs, data, or instructions. For example, programs and/or data stored in the memory 240 may be temporarily stored in the RAM 220 according to the control or boot code of the processor 210. The RAM 220 may be implemented as a memory such as dynamic RAM (DRAM), static RAM (SRAM), or the like.

The neural network device 230 may perform an operation of the neural network based on the received input data and generate an information signal based on the execution result. The neural network may include, but is not limited to, CNN, RNN, FNN, long short-term memory (LSTM), stacked neural network (SNN), state-space dynamic neural network (SSDNN), deep belief networks (DBN), restricted Boltzmann machine (RBM), and the like. The neural network device 230 may be a hardware accelerator itself dedicated to a neural network or an apparatus including the same. The neural network device 230 may perform a read or write operation as well as an operation of the neural network.

The neural network device 230 may correspond to the neural network device 100 or 100a according to the embodiment illustrated in FIG. 3 or 13. Since the neural network device 230 may implement weights having linear state change characteristics, accuracy of neural network operations performed by the neural network device 230 may be increased, and a more sophisticated neural network may be implemented. The neural network device 230 may be integrally manufactured on one substrate together with logic circuits including the processor 210. In other words, the neural network device 230 may include logic circuits including the processor 210 as one integrated circuit. Alternatively, the neural network device 230 may be manufactured separately from logic circuits including the processor 210 and then packaged together in one package.

The information signal may include one of various types of recognition signals such as a voice recognition signal, an object recognition signal, an image recognition signal, a biometric information recognition signal, and the like. For example, the neural network device 230 may receive frame data included in the video stream as input data and generate, from frame data, a recognition signal for an object included in an image represented by the frame data. However, the neural network device is not limited thereto, and the neural network device 230 may receive various types of input data and generate a recognition signal according to the input data according to the type or function of the device on which the electronic apparatus 200 is mounted.

The neural network device 230 may perform, for example, machine learning model such as linear regression, logistic regression, statistical clustering, Bayesian classification, decision trees, principal component analysis, and/or expert system, and/or machine learning model of ensemble techniques, etc., such as random forest. The machine learning model may be used to provide various services such as, for example, image classification service, user authentication service based on biometric information or biometric data, advanced driver assistance system (ADAS), voice assistant service, automatic speech recognition (ASR) service, and the like.

The memory 240 is a storage place for storing data and may store an operating system (OS), various programs, and various pieces of data. In an embodiment, the memory 240 may store intermediate results generated during the operation of the neural network device 230.

The memory 240 may be a DRAM, but is not limited thereto. The memory 240 may include at least one of a volatile memory and a nonvolatile memory. The nonvolatile memory includes read-only memory (ROM), programmable ROM (PROM), electrically programmable ROM (EPROM), electrically erasable and programmable ROM (EEPROM), flash memory, phase-change ROM (PROM), magnetic ROM (MROM), resistive ROM (RROM), ferroelectric ROM (FROM), and the like. The volatile memory includes dynamic RAM (DRAM), static RAM (SRAM), synchronous DRAM (SDRAM), phase-change RAM (PRAM), magnetic RAM (MRAM), resistive RAM (RRAM), and ferroelectric RAM (FeRAM). In an embodiment, the memory 240 may include at least one of a hard disk drive (HDD), a solid state drive (SSD), a compact flash (CF), a secure digital (SD), a micro secure digital (Micro-SD), a mini secure digital (Mini-SD), and a memory stick.

The sensor module 250 may collect information around a device on which the electronic apparatus 200 is mounted. The sensor module 250 may sense or receive a signal (e.g., an image signal, a voice signal, a magnetic signal, a bio signal, a touch signal, etc.) from the outside of the electronic apparatus 200 and convert the sensed or received signal into data. To this end, the sensor module 250 may include at least one of various types of sensing devices such as a microphone, an imaging device, an image sensor, a light detection and ranging (LIDAR) sensor, an ultrasonic sensor, an infrared sensor, a biosensor, and a touch sensor.

The sensor module 250 may provide the converted data to the neural network device 230 as input data. For example, the sensor module 250 may include an image sensor, generate a video stream by photographing an external environment of the electronic apparatus 200, and sequentially provide the continuous data frame of the video stream to the neural network device 230 as input data. However, embodiments are not limited thereto, and the sensor module 250 may provide various types of data to the neural network device 230.

The communication module 260 may include various wired or wireless interfaces capable of communicating with an external device. For example, the communication module 260 may include a communication interface capable of connecting to a wired local area network (LAN), a wireless local area network (WLAN) such as a wireless fidelity (Wi-Fi), a wireless personal area network (WPAN) such as Bluetooth, a wireless universal serial bus (USB), Zigbee, near field communication (NFC), radio-frequency identification (RFID), power line communication (PLC), and a mobile cellular network, such as 3rd generation (3G), 4th generation (4G), long term evolution (LTE), and the like.

In the embodiments described above, it has been described that the vertically stacked transistor structure is applied to synaptic devices of neural network devices, but embodiments are not limited thereto. The vertically stacked transistor structure described above may be applied to various devices in which one unit cell includes two or more transistors in addition to synaptic devices. For example, if one unit cell, such as an image sensor or memory, includes two or more transistors, the vertically stacked transistor structure described above may be applied to unit cells such as image sensors and memories.

The vertically stacked transistor structure and neural network device including the same described above have been described with reference to embodiments illustrated in the drawings, but are merely examples.

One or more of the elements disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

**Claims**

1. A vertically stacked transistor structure comprising:

   a first transistor including a first channel, a first source region, a first drain region, a first gate insulating layer, and a first gate electrode; and
   a second transistor on the first transistor in a first direction and including a second channel, a second source region, a second drain region, a second gate insulating layer, and a second gate electrode, wherein
   one of the first gate insulating layer and the second gate insulating layer includes a paraelectric material, and
   an other of the first gate insulating layer and the second gate insulating includes a data recording material.

2. The vertically stacked transistor structure of claim 1, wherein

the first source region, the first channel, and the first drain region of the first transistor are sequentially provided in a second direction, the second direction is perpendicular to the first direction, and the second drain region, the second channel, and the second source region of the second transistor are sequentially provided in the second direction.

3. The vertically stacked transistor structure of claim 2, wherein

the first channel of the first transistor faces the second channel of the second transistor, the first channel of the first transistor and the second channel of the second transistor are spaced apart from each other in the first direction, the first source region of the first transistor faces the second drain region of the second transistor, the first source region of the first transistor and the second drain region of the second transistor are spaced apart from each other in the first direction, and the first drain region of the first transistor faces the second source region of the second transistor, and the first drain region of the first transistor and the second source region of the second transistor are spaced apart from each other in the first direction.

4. The vertically stacked transistor structure of claim 3, wherein a distance between the first channel of the first transistor and the second channel of the second transistor in the first direction is 3 nm to 30 nm.

5. The vertically stacked transistor structure of claim 3 or 4, further comprising:

an insulating layer, wherein the insulating layer is between the first source region of the first transistor and the second drain region of the second transistor, the first source region of the first transistor and the second drain region of the second transistor face each other, the insulating layer is between the first drain region of the first transistor and the second source region of the second transistor, and the first drain region of the first transistor and the second source region of the second transistor face each other.

6. The vertically stacked transistor structure of claim 1, wherein

the first gate insulating layer surrounds the first channel, the first gate electrode surrounds the first gate insulating layer, the second gate insulating layer surrounds the second channel, and the second gate electrode surrounds the second gate insulating layer.

7. The vertically stacked transistor structure of claim 6, wherein

the first gate electrode of the first transistor faces the second gate electrode of the second transistor, and the first gate electrode of the first transistor and the second gate electrode of the second transistor are spaced apart from each other in the first direction.

8. The vertically stacked transistor structure of claim 7, further comprising:
an insulating layer between the first gate electrode of the first transistor and the second gate electrode of the second transistor.

9. The vertically stacked transistor structure of any of claims 6 to 8, wherein

the first gate insulating layer surrounds three or four surfaces of the first channel, and the second gate insulating layer surrounds three or four surfaces of the second channel.

10. The vertically stacked transistor structure of any of claims 6 to 9, further comprising:

spacers extending in the first direction, wherein the spacers contact both sides of the first gate insulating layer and both sides of the first gate electrode of the first transistor in a second direction, the spacers contact both sides of the second gate insulating layer and both sides of the second gate electrode of the second transistor in the second direction, and the second direction is perpendicular to the first direction.

11. The vertically stacked transistor structure of any preceding claim, further comprising:

a substrate, wherein the first channel, the first source region, and the first drain region of the first transistor protrude from an upper surface of the substrate in the first direction.

12. The vertically stacked transistor structure of any preceding claim, further comprising:
a conductor extending in the first direction and electrically connecting the first drain region of the first transistor with the second source region of the second transistor.

13. The vertically stacked transistor structure of any of claims 1 to 11, further comprising:
a conductor electrically connecting the first drain region of the first transistor with the second gate electrode of the second transistor.

14. The vertically stacked transistor structure of any preceding claim, wherein
the data recording material includes a ferroelectric material or the data recording material includes a charge trap material having an ONO multilayer structure.

15. A neural network device comprising:

an array of a plurality of synaptic devices arranged in two dimensions along a plurality of rows and a plurality of columns, wherein
the plurality of synaptic devices include a vertically stacked transistor structure according to any preceding claim.

# FIG. 1

# FIG. 2

# FIG. 3

# FIG. 4

110

mTR

131
134
135

d

112

sTR

121
124
125

111

Z

X

# FIG. 5

# FIG. 6A

# FIG. 6B

130

141

120

Z

Y

X

111

# FIG. 6C

# FIG. 6D

# FIG. 6E

# FIG. 6F

# FIG. 6G

# FIG. 6H

# FIG. 6I

# FIG. 6J

# FIG. 6K

# FIG. 7

EP 4 676 183 A1

# FIG. 8

110a

sTR

121
124
125

112

mTR

131
134
135

111

Z

X

# FIG. 9

110b

mTR

131
134
135

112

sTR

121
124
125

111

Z

X

# FIG. 10

110c

sTR

121
124
125

112

mTR

131
134
135

111

Z
X

# FIG. 11

# FIG. 12

110e

sTR

- 121
- 124
- 125

- 112

mTR

- 131
- 134
- 135

- 111

Z
X

# FIG. 13

# FIG. 14

EP 4 676 183 A1

# FIG. 15

| | Europäisches Patentamt<br>European Patent Office<br>Office européen des brevets | **EUROPEAN SEARCH REPORT** | **Application Number**<br>EP 25 18 4253 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/375926 A1 (MEHANDRU RISHABH [US] ET AL) 2 December 2021 (2021-12-02)<br>* paragraphs [0055], [0064], [0065], [0145]; figures 3,4 *<br>----- | 1-15 | INV.<br>H10B51/30<br>H10B43/20<br>H10B43/30<br>H10B51/20 |
| A | CHOE GIHUN ET AL: "Advanced Gate Stack Design of Ferroelectric Transistor for Scaling towards 7nm FinFET Platform",<br>2021 SILICON NANOELECTRONICS WORKSHOP (SNW), JSAP,<br>13 June 2021 (2021-06-13), pages 1-2,<br>XP033956395,<br>DOI: 10.1109/SNW51795.2021.00017<br>[retrieved on 2021-07-27]<br>* figure 2(a) *<br>----- | 11 | ADD.<br>H10D64/68 |
| A | US 2010/091572 A1 (CHOI WOONG LIM [KR]) 15 April 2010 (2010-04-15)<br>* figure 1 *<br>----- | 12 | |
| A | LI XUEQING ET AL: "Nonvolatile Memory and Computing Using Emerging Ferroelectric Transistors",<br>2018 IEEE COMPUTER SOCIETY ANNUAL SYMPOSIUM ON VLSI (ISVLSI), IEEE,<br>8 July 2018 (2018-07-08), pages 750-755,<br>XP033382484,<br>DOI: 10.1109/ISVLSI.2018.00141<br>[retrieved on 2018-08-07]<br>* figure 5(a) *<br>----- | 13 | TECHNICAL FIELDS SEARCHED (IPC)<br><br>H10B<br>H10D |

-/--

The present search report has been drawn up for all claims

| Place of search | Date of completion of the search | Examiner |
|---|---|---|
| Munich | 20 November 2025 | Günay Demirkol, Anil |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

# EUROPEAN SEARCH REPORT

Application Number

EP 25 18 4253

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SOURAV DE ET AL: "Random Variations in Hf_0.5Zr_0.5O_2 based FE-finFETs: A Synergistic Approach of Interfacial Layer Engineering and Mixed Precision Architecture to Mitigate the Implications on Deep Neural Networks", ARXIV.ORG, CORNELL UNIVERSITY LIBRARY, 201 OLIN LIBRARY CORNELL UNIVERSITY ITHACA, NY 14853, 28 July 2020 (2020-07-28), XP081838265, * figure 6 * ----- | 15 | |
| | | | TECHNICAL FIELDS SEARCHED (IPC) |

The present search report has been drawn up for all claims

| Place of search | Date of completion of the search | Examiner |
|---|---|---|
| Munich | 20 November 2025 | Günay Demirkol, Anil |

EPO FORM 1503 03.82 (P04C01)

**EP 4 676 183 A1**

## ANNEX TO THE EUROPEAN SEARCH REPORT
## ON EUROPEAN PATENT APPLICATION NO.

EP 25 18 4253

20-11-2025

| Patent document cited in search report | Publication date | Patent family member(s) | Publication date |
|---|---|---|---|
| US 2021375926 A1 | 02-12-2021 | NONE | |
| US 2010091572 A1 | 15-04-2010 | CN 101573764 A | 04-11-2009 |
| | | JP 2010514196 A | 30-04-2010 |
| | | KR 20080058749 A | 26-06-2008 |
| | | TW 200830541 A | 16-07-2008 |
| | | US 2010091572 A1 | 15-04-2010 |
| | | WO 2008078877 A1 | 03-07-2008 |